# EUROPÄISCHE PATENTANMELDUNG

(11) **EP 0 841 839 A1**
(43) Veröffentlichungstag der Anmeldung: **13.05.1998**
(21) Anmeldenummer: 96250255.5
(22) Anmeldetag: 06.11.1996
(51) Int. Cl.: H05K 3/18, C23C 18/16

(54) **Verfahren zum Strukturieren von Kunststoffoberflächen, insbesondere zur Herstellung von Mitteln zur irreversiblen Informationsspeicherung**

(71) Anmelder: ATOTECH Deutschland GmbH, 10553 Berlin (DE)
(72) Erfinder: Guggemos, Michael, 14532 Stahnsdorf (DE); Kohnle, Franz, 12357 Berlin (DE); Gedrat, Klaus, 13465 Berlin (DE)
(74) Vertreter: Bressel, Burkhard, Dr.

(57) **Zusammenfassung**

Es wird ein Verfahren zum Strukturieren von Kunststoffoberflächen, insbesondere zur Herstellung von Mitteln zur irreversiblen Informationsspeicherung beschrieben.

Bekannte Speichermedien mit einem irreversiblen Speichermechanismus enthalten oberflächlich aufgebrachte Muster, bestehend aus Metallschichten, wobei die erste, auf dem Trägermaterial anliegende Schicht aus einer Nickel/Phosphor-Legierung und die zweite aus einer Zinn/Blei-Legierungsschicht besteht. Zur Herstellung der Muster werden übliche Photoresiste auf den Kunststoffträgern eingesetzt.

Bei dem erfindungsgemäßen Verfahren werden photoempfindliche Polymerschichten eingesetzt, die mittels sechswertiger Chromverbindungen sensibilisiert sind. Im Anschluß an die Bildung der Schaltungsstrukturen in den Polymerschichten werden die Substrate zur Härtung der Polymere und gleichzeitig zur Aufrauhung der freiliegenden Kunststoffoberflächen mit einer Chromsäure enthaltenden Lösung behandelt.

## Beschreibung

Die vorliegende Erfindung betrifft ein Verfahren zum Strukturieren von Kunststoffoberflächen, insbesondere zur Herstellung von Mitteln zur irreversiblen Informationsspeicherung.

In zunehmendem Maße werden Scheckkarten zur bargeldlosen Zahlung an Automaten verwendet. Beispielsweise werden derartige Karten zum Telefonieren an öffentlichen Telefonzellen eingesetzt. Ebenso werden diese Karten im bargeldlosen Zahlungsverkehr bei beliebigen Kaufgeschäften verwendet. Diese Karten dienen auch zur digitalen Datenerfassung, beispielsweise beim Besuch von Ärzten.

In der Regel werden die Daten auf diesen Datenträgern, beispielsweise das durch Einzahlung auf ein Konto gespeicherte Geldguthaben, mittels eines Magnetstreifens oder auch bei aufwendigeren Kartensystemen auf einem in die Karte integrierten Halbleiterspeicher festgehalten.

Diese Systeme weisen jedoch verschiedene Nachteile auf. Insbesondere für den Fall, daß nur ein einmal durch Einzahlung eines bestimmten Geldguthabens gespeicherter Betrag festgehalten und jeweils nur ein bestimmter Betrag von dem gespeicherten Guthaben wieder subtrahiert und der neue Betrag gespeichert werden soll, stellen die genannten Speichermedien unwirtschaftliche und störanfällige Systeme dar. Vor allem mit Magnetstreifen versehene Karten sind gegen Mißbrauch nur unzureichend geschützt, da das gespeicherte Guthaben relativ einfach geändert werden kann.

Daher wurden neue Speicherungsverfahren gesucht. In der brasilianischen Patentanmeldung BR-A- 910 55 85 ist ein Verfahren zur Herstellung von Zählkarten für öffentliche Fernsprechapparate beschrieben, bei dem auf ein nicht-durchlässiges, nicht-poröses Substrat eine ganzflächige erste leitfähige Schicht mit höherem elektrischen Widerstand mit chemischen Methoden, vorzugsweise eine Nickelschicht mit maximal 0,3 µm Dicke, und danach eine 2 bis 8 µm dicke, elektrolytisch ganzflächig abgeschiedene Metall- oder Legierungsschicht mit deutlich geringerem Widerstand und Schmelzpunkt als der ersten Schicht, vorzugsweise eine Zinn/Blei-Schicht, aufgebracht wird. Bei der elektrolytischen Abscheidung sollen geringe Stromdichten von 0,5 bis 2 A/dm² angewendet werden.

Mittels der nach diesem Verfahren hergestellten Speicherkarte werden Geldguthaben dadurch gespeichert, daß beim Herstellprozeß eine Feldmatrix in der Karte erzeugt wird, die aus einzelnen miteinander elektrisch verbundenen leitfähigen Felder gebildet ist, wobei diese Felder jeweils aus eckigen oder runden Ringen bestehen, die an einer Stelle durch einen schmalen Steg geschlossen sind. Um das gespeicherte Geldguthaben durch eine Lesevorrichtung abzurufen, werden kleine Spulen über den einzelnen Feldern plaziert und durch Induktion eines Stromes in den Ringen gemessen, wie viele dieser Ringe geschlossen sind. Bei einer Reduktion des Geldguthabens werden die schmalen Stege der Felder sukzessive wiederum durch Induktion eines Stromes, der in diesem Fall aber größer eingestellt wird, zerstört, so daß beim nachfolgenden Auslesen festgestellt werden kann, wie viele unzerstörte geschlossene Ringe noch bestehen.

Diese Mittel zur irreversiblen Informationsspeicherung sind wesentlich weniger störanfällig und fälschungssicherer als die herkömmlichen Speicherkarten.

In der genannten brasilianischen Patentanmeldung ist ein Verfahren zur Herstellung dieser Telefonkarten offenbart. Danach werden die angegebenen Metallschichten zunächst ganzflächig erzeugt und die einzelnen Felder durch geeignete Ätzprozesse mit Hilfe von struktierten Ätzmasken gebildet.

Dieses Verfahren ist jedoch aufwendig und daher unwirtschaftlich. Insbesondere die schmalen Stege in den Ringen, die beispielsweise nur 100 µm breit sind, können mit den Ätzprozessen nur schwierig hergestellt werden. Da diese Telefonkarten in sehr hohen Stückzahlen produziert werden, werden vorzugsweise viele derartiger Karten in einem Arbeitsgang auf großen Kunststoffsubstraten hergestellt, so daß die schmalen Stege wegen des zwangsläufigen Versatzes beim Strukturieren der Metallschichten mittels geeigneter Masken mitunter an den falschen Stellen plaziert werden. Es bereitet auch häufig Probleme, die Breite der schmalen Stege überhaupt reproduzierbar einzustellen. Daher kann es vorkommen, daß ein derartiger Steg bereits beim Auslesen der gespeicherten Information zerstört wird, wenn dessen Breite eine bestimmte Grenze unterschreitet und der Widerstand der Stege dadurch ebenfalls einen oberen Grenzwert überschreitet.

Daher wird in DE 44 38 799 A1 ein verbessertes Verfahren zur Herstellung derartiger Speichermedien vorgeschlagen. Bei diesem Verfahren wird auf den nichtleitenden Kartenträger zunächst ganzflächig ein für die stromlose Abscheidung von Metallen geeigneter Katalysator aufgebracht. Anschließend werden die miteinander verbundenen Strukturen auf der Trägeroberfläche mittels einer Maskentechnik abgebildet. Danach wird zunächst eine erste dünne Metallschicht stromlos und danach eine zweite dickere Metallschicht elektrolytisch abgeschieden. Als erste Metallschicht wird wiederum eine Nickelschicht und als zweite Metallschicht eine Zinn/Blei-Legierungsschicht vorgeschlagen. Dieses Verfahren kommt ohne Ätzschritte aus.

Die bekannten Verfahren weisen den Nachteil auf, daß relative teure Galvanoresistmaterialien eingesetzt werden müssen, insbesondere um die feinen Stege in den Metallstrukturen herzustellen. Des weiteren werden lange Verfahrensfolgen durchlaufen. Dies führt dazu, daß eine Vielzahl von galvanotechnischen Bädern überwacht werden müssen, so daß die Fehleranfälligkeit des Gesamtprozesses hoch ist. Außerdem muß der galvanotechnische Prozeß bei den bekannten Verfahren unterbrochen werden, um die Strukturen an den Substratoberflächen mittels geeigneter Resiste abzubilden. Die Strukturierung mit den Resisten wird üblicherweise in separaten Anlagen durchgeführt, so daß die Herstellung durch das erforderliche Neueinrichten der zu behandelnden Substrate teuer und fehleranfällig wird. Die bei den bekannten Verfahren verwendeten Resistmaterialien müssen auch sowohl gegenüber den Kunststoffätzlösungen als auch den Metallisierungsbädern chemisch stabil sein, d.h. die Resiste dürfen weder angegriffen werden, noch dürfen Resistbestandteile durch das sogenannte "Ausbluten" des Resists in die Behandlungslösungen gelangen. Dies schränkt die Anzahl der verwendbaren Resisttypen ein. Darüber hinaus wird bei dem in DE 44 38 799 A1 offenbarten Verfahren die gesamte Substratoberfläche für die nachfolgende stromlose Metallisierung katalysiert, so daß unter ungünstigen Verhältnissen beim Herstellverfahren auch auf den nichtleitenden Bereichen zwischen den Leiterstrukturen eine endliche elektrische Leitfähigkeit gemessen werden kann. Dadurch kann die Funktionstüchtigkeit des mit den Metallstrukturen versehenen Substrats beeinträchtigt werden.

Schließlich enthält die elektrolytisch abgeschiedene Metallschicht als giftiges Metall Blei und bereitet daher zum einen Probleme bei der Abwasseraufbereitung beim galvanotechnischen Herstellprozeß und bei der Deponie von Abfallstoffen aus dem Herstellverfahren; zum anderen verursachen auch die Karten selbst erhebliche Abfallprobleme, da Telefonkarten häufig achtlos zusammen mit gewöhnlichem Abfall verworfen werden, so daß wegen des Bleianteils eine erhöhte Umweltbelastung hervorgerufen wird.

Der vorliegenden Erfindung liegt von daher das Problem zugrunde, ein Verfahren zum Strukturieren von Oberflächen von Kunststoffsubstraten und insbesondere ein Verfahren zur Herstellung von Mitteln zur irreversiblen Informationsspeicherung zu finden, mit dem die Nachteile der bekannten Verfahren vermieden werden können. Die Verfahren sollen insbesondere kostengünstig und wenig störanfällig sein und deutlich geringere Umweltbelastungen verursachen als die bekannten Verfahren. Ferner sollen durch die Verwendung der mit den Verfahren hergestellten Mittel auch geringere Abfallprobleme entstehen.

Das Problem wird gelöst durch ein Verfahren zum Strukturieren von Oberflächen von Kunststoffsubstraten nach Anspruch 1, ein Verfahren zur Herstellung von Mitteln zur irreversiblen Informationsspeicherung nach Anspruch 13 sowie ein Herstellverfahren für elektronische Zählsysteme, insbesondere von Telefonkarten, nach Anspruch 14.

Das erfindungsgemäße Verfahren zum Strukturieren von Kunststoffoberflächen mit einem Schaltungsmuster weist die folgenden Verfahrensmerkmale auf:
a) die Kunststoffoberflächen werden zunächst mit einer photoempfindlichen Schicht überzogen;
b) danach wird die photoempfindliche Schicht mit dem Schaltungsmuster belichtet und entwickelt;
c) danach werden die Kunststoffsubstrate mit einer sechswertige Chromverbindungen enthaltenden wäßrigen Lösung aufgerauht.

Erfindungsgemäß wird als photoempfindliche Schicht eine mittels sechswertiger Chromverbindungen sensibilisierte Schicht aus Polymeren verwendet. Als Polymere werden vorzugsweise natürliche oder synthetische Proteine oder Kohlenhydrate oder andere synthetische Polymere und insbesondere Casein, Gelatine, Gummi arabicum, Schelllack, Fischleim, Albumin, Stärke, Polyvinylalkohol, Polyvinylpyrrolidon oder Polyvinylbutyral verwendet.

Durch Verwendung eines derartigen Resists ist eine sehr kostengünstige Herstellung der strukturierten Kunststoffoberflächen möglich, da diese Resisttypen außerordentlich billig sind. Ferner sind diese Resiste auch gegenüber den üblicherweise zur Aufrauhung der Kunststoffoberflächen verwendeten Lösungen, die Chromsäure enthalten, resistent.

Da diese Resiste zur Sensibilisierung sechswertige Chromverbindungen, vorzugsweise Dichromate, enthalten und zu deren weiterer Härtung nach dem Entwicklungsprozeß nachträglich sogar noch mit Chromsäure enthaltdenden Mitteln behandelt werden sollen, ergibt sich ihre Widerstandsfähigkeit gegenüber diesen Chemikalien von selbst. Der Vorteil des erfindungsgemäßen Verfahrens besteht gerade darin, daß die nachträgliche Härtung des Resists mit der erforderlichen Substrataufrauhung kombiniert werden kann, mit der weiteren vorteilhaften Folge daß ein zusätzlicher Verfahrensschritt eingespart wird. Die mit der nachträglichen Härtung erreichte erhöhte Prozeßsicherheit wird daher automatisch mit einer verkürzten Verfahrensdauer kombiniert. Indem ferner die Kunststoffoberflächen mittels Chromsäure oder Chrom/Schwefelsäure erst nach der Strukturierung mit der photoempfindlichen Schicht aufgerauht werden, muß der galvanotechnische Prozeß für den Photoprozeß nicht unterbrochen werden. Vielmehr können die Kunststoffsubstrate zunächst in den für den Photoprozeß geeigneten Anlagen behandelt und danach in der galvanotechnischen Anlage weiterbearbeitet werden. Dadurch ist es nicht erforderlich, die Substrate mehrfach von einer Behandlungsanlage zu einer anderen zu transportieren und außerdem jedesmal neu in dafür vorgesehene Befestigungseinrichtungen für die Behandlung in den einzelnen Anlagen einzuspannen. Aus diesem Grunde ist das erfindungsgemäße Verfahren billiger und einfacher und folglich auch sicherer als die bekannten Verfahren.

Zur Herstellung von Metallstrukturen auf den Kunststoffoberflächen werden diese nach der Aufrauhung zunächst aktiviert. Hierzu dienen übliche Lösungen, die katalytisch aktive Metalle, wie beispielsweise Palladium in der Form eines mittels Zinn(II)-Verbindungen stabilisierten Kolloids, enthalten.

In einer bevorzugten Ausführungsform kann auf den separaten Aktivierungsschritt verzichtet werden, wenn der die Chromsäure enthaltenden Lösung auch die katalytisch aktiven Metalle in Form ihrer Verbindungen zugegeben werden. Dadurch kann ein weiterer Verfahrensschritt eingespart werden.

Beide Verfahrensvarianten bieten gegenüber dem in DE 44 38 799 A1 beschriebenen Verfahren den zusätzlichen Vorteil, daß nur die zu metallisierenden Bereiche der Kunststoffoberflächen aktiviert werden, nicht jedoch die Bereiche, die später frei von Metall bleiben sollen. Dadurch wird die Gefahr der Metallisierung an diesen Stellen vollständig beseitigt.

Nach der Aktivierung können die metallischen Schichten auf die Kunststoffoberflächen aufgebracht werden. In einer bevorzugten Ausführungsform werden die photoempfindlichen Polymerschichten vor der Metallisierung entfernt. Auch dadurch wird eine erhöhte Verfahrenssicherheit erreicht, weil eine Metallisierung in den nicht zu metallisierenden Bereichen der Kunststoffoberflächen verhindert wird, denn dort ist lediglich die Polymerschicht mit den katalytisch aktiven Metallen in Kontakt gebracht worden.

Die genannten Verfahren sind bevorzugt zur Herstellung von Mitteln zur irreversiblen Informationsspeicherung, bestehend aus einem Kunststoffsubstrat mit Metallstrukturen an dessen Oberflächen, insbesondere elektronischer Zählsysteme, wie beispielsweise Telefonkarten, geeignet.

Derartige Mittel zur irreversiblen Informationsspeicherung sind dadurch gekennzeichnet, daß sie einen vorzugsweise flachen, elektrisch nichtleitenden Träger mit oberflächlich aufgebrachten Strukturen aus Metallschichten umfassen. Die Metallstrukturen bestehen im wesentlichen aus nebeneinander angeordneten Feldern, die elektrisch leitend miteinander verbunden sind. Die Felder bestehen im wesentlichen aus einem Ring, der rund oder eckig ausgebildet sein kann. In diesem Ring kann ein elektrischer Strom induziert werden, wobei der Ring an mindestens einer Stelle durch einen so schmalen Steg geschlossen ist, daß der induzierte Strom ausreicht, die auf dem Steg abgeschiedene Metallschicht zu schmelzen und den Steg zu unterbrechen. Die Dicke der ersten Metallschicht beträgt etwa 0,3 µm und die der zweiten etwa 8 µm.

Als erste Metallschicht wird vorzugsweise ein Metall mit relativ geringer elektrischer Leitfähigkeit, als zweite Metallschicht ein Metall mit einem niedrigen Schmelzpunkt verwendet. Vorzugsweise soll der Schmelzpunkt dieses zweiten Metalls unter etwa 350 °C liegen, das bevorzugt ein Eutektikum bildet. Die erste Schicht wird stromlos abgeschieden und besteht vorzugsweise im wesentlichen aus Nickel, beispielsweise reinem Nickel, einer Nickel/Bor- oder einer Nickel/Phosphor-Legierung. Die zweite Schicht wird elektrolytisch abgeschieden und besteht vorzugsweise aus einer Zinn/Zink- oder Zinn/Blei-Legierung.

Die Abscheidung einer Zinn/Zink-Legierung auf den Kunststoffoberflächen bietet den weiteren Vorteil, daß weniger Probleme bei der Abwasserentsorgung des Metallisierungbades und der Spülwässer sowie bei der Deponie der Galvanikschlämme bestehen als bei Verwendung eines Zinn/Blei-Bades, da Zink deutlich weniger giftig ist als Blei. Auch die anstelle der Zinn/Blei-Legierungsschicht abgeschiedene Zinn/Zink-Legierungsschicht erweist sich als sehr viel weniger giftig als die bekannten Zinn/Blei-Legierungsschichten. Außerdem entstehen auch weniger giftige Abfälle, wenn die mit der Legierung beschichteten elektronischen Zählkarten unsachgemäß in den Abfall gelangen.

Ferner sind Zinn/Zink-Legierungsschichten in den Zählsystemen als Funktionsschicht hervorragend geeignet. Durch deren relativ geringen Schmelzpunkt von etwa 190 bis 230 °C können diese Legierungsschichten problemlos durch geringe Induktionsströme zum Abbuchen einer gespeicherten Guthabeneinheit aufgeschmolzen werden, so daß die aus derartigen Legierungsschichten hergestellten schmalen Stege in den ringförmigen Spulen auf den Trägerkarten leicht zerstört werden können. Wegen ihres geringen Schmelzpunktes wird außerordentlich wenig Energie beim Abbuchen der Guthabeneinheiten verbraucht, und die Karten werden thermisch nur unwesentlich belastet, so daß die häufig auf die Außenseite dieser Karten aufgebrachten dekorativen Schutzlacke nicht beschädigt werden.

Außerdem sind die Rohstoffe zur Herstellung dieser Legierungsschichten außerordentlich preisgünstig. Einer weiterer Vorteil besteht darin, daß lösliche Anoden für beide Legierungselemente nebeneinander oder auch unlösliche Anoden verwendet werden können.

Nachfolgend werden die einzelnen Verfahrensschritte zur Herstellung von mit Metallstrukturen versehener Kunststoffoberflächen und insbesondere von Mitteln zur irreversiblen Informationsspeicherung detailliert beschrieben:

Als Kunststoffsubstrate werden Platten oder Folien von thermoplastischen Polymeren verwendet. Bevorzugt werden Substrate aus Acrylnitril/Butadien/Styrol-Copolymer (ABS), Polyvinylchlorid oder einer Mischung dieser Kunststoffe verwendet. Außerdem können auch duroplastische Polymere, wie beispielsweise Epoxidharze, beispielsweise als Verbundwerkstoffe, eingesetzt werden. Da häufig nur eine Seite dieser Platten oder Folien mit strukturierten Metallschichten versehen werden müssen, werden zwei Platten bzw. Folien mit ihren Rückseiten miteinander verbunden, so daß Behandlungsflüssigkeit nicht dazwischen gelangen kann. Hierzu werden die Platten bzw. Folien beispielsweise an den Rändern miteinander verschmolzen.

Vor der Beschichtung der Kunststoffsubstrate werden diese zunächst gereinigt. Hierzu können beispielsweise wäßrige Lösungen von Netzmitteln oder organische Lösungsmittel sowie erwärmtes Wasser verwendet werden. Die Reinigungswirkung kann durch mechanische Bewegung der Behandlungslösung unterstützt werden. Besonders wirkungsvoll ist die zusätzliche Anwendung von Ultraschall. Außerdem können beispielsweise auch oxidierende Lösungen, wie beispielsweise alkalische Permanganat-Lösungen oder sechswertige Chromverbindungen enthaltende Lösungen eingesetzt werden. Eine andere vorteilhafte Methode zum Reinigen besteht darin, das Kunststoffsubstrat durch Bestrahlen mit einer Bimsmehl/Wasser-Suspension oberflächlich anzurauhen. Dabei werden auch Verunreinigungen entfernt. Selbstverständlich können die beiden Alternativen auch kombiniert werden. Danach werden die Oberflächen getrocknet.

Das derart gereinigte bzw. aufgerauhte Sandwich wird anschließend mit dem photoempfindlichen Polymeren beschichtet.

Als photoempfindliche Polymere werden vorzugsweise solche Verbindungen eingesetzt, die zu einer späteren Nachhärtung nicht zusätzlich noch höhere Temperaturbehandlungen erfordern. Daher sind beispielsweise Casein und Schellack bevorzugt geeignet. Weniger gut einsetzbar ist dagegen Fischleim, das eine höhere Nachbehandlungstemperatur benötigt. Weniger gut verwendbar sind auch Gelatine und Albumin, da diese eine relativ geringe Chemikalienbeständigkeit aufweisen. Geeignet sind jedoch auch die synthetischen Polymere wie Polyvinylalkohol, Polyvinylpyrrolidon und Polyvinylbutyral, wenn auch Polyvinylalkohol bei einer höheren Temperatur nachgehärtet werden muß. Grundsätzlich sind auch andere photoempfindliche Polymere einsetzbar.

Die Polymere werden in wäßrigen oder anderen geeigneten Lösungsmitteln aufgequollen und gelöst. Zur Sensibilisierung der Polymere werden in diese Lösung zusätzlich sechswertige Chromverbindungen gegeben. Üblicherweise dienen hierzu Dichromate, beispielsweise Kalium- oder Ammoniumdichromat. Grundsätzlich können aber auch Chromate verwendet werden. Ferner enthalten diese Lösungen beispielsweise auch Farbstoffe, um beim nachfolgenden Entwicklungsprozeß leicht erkennen zu können, ob das Strukturierungsverfahren fehlerfrei durchgeführt wurde. Durch diese wird der Kontrast zu den nicht beschichteten Oberflächenbereichen des Kunststoffsubstrats erhöht. Als Farbstoff kann beispielsweise Methylviolett verwendet werden. Der Farbstoff kann aber auch in einem späteren Verfahrensschritt auf die Polymerschicht gegeben werden, beispielsweise beim Entwickeln der belichteten Schicht. Ferner können der Beschichtungslösung auch weitere Zusatzstoffe zugegeben werden, beispielsweise Stoffe zur Stabilisierung des pH-Wertes der Lösung (pH-Puffer) und Mittel, die den biologischen Abbau oder die Widerstandsfähigkeit gegen Bakterien, Pilze und andere Stoffe verhindern.

Durch den weiteren Zusatz von Verbindungen von Silber, Kupfer und/oder Eisen zu der Lösung wird die chemische Widerstandsfähigkeit der photoempfindlichen Schicht weiter erhöht. Beispielsweise kann die wäßrige Polymerlösung Eisen(III)-chlorid enthalten.

Vorzugsweise wird die Lösung vor der Beschichtung noch mehrere Tage lang ausgereift.

Zur Beschichtung der Kunststoffoberflächen werden die Polymere zusammen mit den sechswertigen Chromverbindungen in wäßriger Lösung angesetzt und in dieser Form auf die Oberflächen aufgebracht. Zur Beschichtung können die Lösungen durch Aufschleudern, Eintauchen, Aufspritzen oder -schwallen, vorzugsweise aber im Roller-Coater-Verfahren, bei dem die Lösung zunächst auf eine erste Rolle aufgetragen und von dieser durch Abrollen auf die Kunststoffoberflächen aufgebracht wird, durch ein Vorhanggießverfahren oder durch Siebdurck aufgetragen werden. Das zuletzt genannte Verfahren ermöglicht den selektiven Druck auf bestimmte Bereiche der Oberflächen. Das Roller-Coater-Verfahren kann vorteilhaft in einer kontinuierlichen Durchlaufanlage angewendet werden.

Falls mit der Siebdrucktechnik gearbeitet wird, wird das photoempfindlicche Polymer bei einem Mehrfachnutzen zunächst ausschließlich auf die Flächen, die einem Schaltungsmuster entsprechen, aufgedruckt, ohne daß die einzelnen Strukturelemente herausgearbeitet werden. In einem zweiten Arbeitsgang kann dann die Schaltungsstruktur durch den anschließenden Belichtungs-/Entwicklungsprozeß gebildet werden. Dadurch können feinste Strukturelemente abgebildet und gleichzeitig nicht verwendbare Flächen zwischen den einzelnen Schaltungen auf dem Mehrfachnutzen durch das Siebdrucken ausgespart werden.

Eine weitere Verfahrensvariante besteht darin, einen Photoresist auf die Trägeroberflächen so im Siebdruckverfahren aufzudrucken, daß die Schaltungsmuster bereits beim Drucken entstehen, und die schmalen Stege erst durch einen nachfolgenden Belichtungs-/Entwicklungsprozeß gebildet werden.

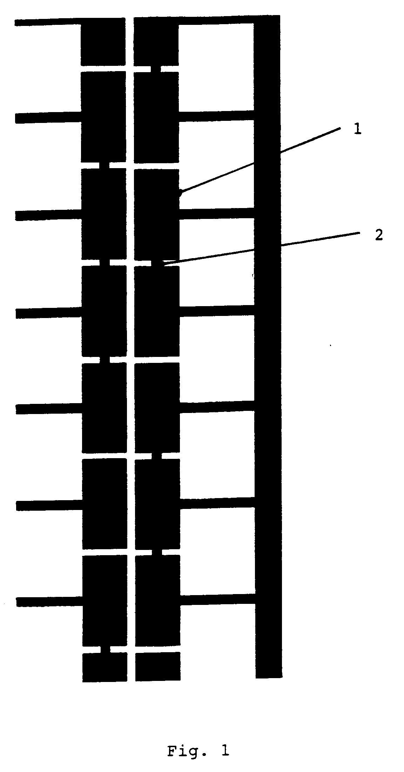

Nach der Polymerschichtbildung wird das beschichtete Kunststoffsubstrat gegebenenfalls unter Wärmeeinwirkung getrocknet. Anschließend werden die Substratoberflächen belichtet. Hierzu wird ein positives Bild der zu bildenden Metallstrukturen auf die Polymerschichten abgebildet. Ein Beispiel ist in Figur 1 angegeben. Die belichteten Bereiche sind dort dunkel wiedergegeben.

Danach werden die belichteten Schichten entwickelt. Hierzu werden diese mit warmem Wasser in Kontakt gebracht. Vorzugsweise wird das Wasser in einem mäßig scharfen Strahl auf die Oberflächen gerichtet, so daß die unbelichteten Stellen der Polymerschicht von den Kunststoffoberflächen entfernt werden. Um eine möglichst schonende Entwicklung zu erreichen, wird in zwei Stufen entwickelt und zwar mit zwei unterschiedlichen Wassertemperaturen. Dem Wasser können zum Anfärben der Schicht auch Farbstoffe zugegeben werden.

Danach werden die Substrate getrocknet. Zur Verfestigung der Polymerschicht wird diese hierzu erwärmt, beispielsweise in einem Infrarotofen.

Für die nachfolgende galvanotechnische Behandlung werden die Kunststoffträgermaterialien an geeigneten Gestellen befestigt und in senkrechter Lage nacheinander in die verschiedenen Behandlungsbäder eingetaucht.

Die Kunststoffsubstrate werden zur weiteren Härtung der Polymerschicht und zur Aufrauhung der nunmehr freiliegenden Bereiche der Kunststoffoberflächen mit einer sechswertige Chromverbindungen enthaltenden Lösung behandelt. Hierzu dient vorzugsweise eine Chrom/Schwefelsäure-Lösung, beispielsweise mit den Konzentrationen von etwa 360 g Chromsäure (CrO₃)/L Lösung und etwa 360 g Schwefelsäure/L Lösung. Es kann jedoch auch eine reine Chromsäure-Lösung, enthaltend etwa 900 g Chromsäure/L Lösung, eingesetzt werden. Zur Beschleunigung der Reaktion werden die Substrate bei erhöhter Temperatur behandelt.

Im Anschluß daran werden die Kunststoff-Sandwiches wieder gespült und danach mit einer Lösung zur Entfernung von Chrom(VI)-ionen behandelt, beispielsweise mit einer Natriumhydrogensulfit-Lösung.

In einer bevorzugten Ausführungsform des erfindungsgemäßen Verfahrens werden der Ätzlösung zusätzlich katalytisch aktive Metalle, beispielsweise Palladium, in Form ihrer Verbindungen zugesetzt. Hierzu kann beispielsweise Palladiumchlorid (PdCl₂) verwendet werden. Alternativ können auch andere Verbindungen eingesetzt werden, beispielsweise Komplexverbindungen des Palladiums, wie das Chlorid- oder Sulfatsalz des 2-Aminopyridin-Komplexes. In diesem Fall wird anstelle der zuvor genannten Natriumhydrogensulfit-Lösung eine wäßrige Lösung eines starken Reduktionsmittels verwendet, vorzugsweise Dimethylaminoboran oder Natriumborhydrid.

Nach einer weiteren Spülung der Sandwiches mit Wasser werden deren Oberflächen dann aktiviert, wenn der Ätzlösung nicht bereits katalytisch aktive Metalle zugesetzt worden sind. Selbstverständlich kann diese nachträgliche Aktivierung auch zusätzlich zur Aktivierung durch die die Chromsäure enthaltende Lösung durchgeführt werden. Dazu werden die Substrate zunächst mit einer Vortauchlösung behandelt, die im einfachsten Fall aus einer wäßrigen, verdünnten Schwefelsäure-Lösung besteht und zusätzlich Netzmittel enthalten kann. Ohne weitere Spülung werden die vorgetauchten Substrate dann aktiviert. Hierzu wird ein geeigneter Katalysator aufgebracht, um die Oberflächen für die stromlose Metallisierung zu aktivieren. Es werden die üblichen Katalysatoren verwendet, beispielsweise Palladiumkolloide, die mit Zinn(II)-Salzen oder Polymeren, wie beispielsweise Polyvinylalkohol oder Polyvinylpyrrolidon, stabilisiert sind. Die auf den Substraten adsorbierten Palladiumcluster, vermischt mit den Schutzkolloiden, werden von letzteren in einem zweiten Verfahrensschritt befreit (Akzeleration).

Des weiteren können auch sogenannte ionogene Palladiumaktivatoren zur Katalyse eingesetzt werden, bei denen Palladiumkomplexe mit organischen Komplexliganden, beispielsweise 2-Aminopyridin, als Vorstufe für die Katalyse verwendet werden. Die auf den Trägermaterialien adsorbierten Komplexe werden in einer zweiten Verfahrensstufe mittels starker Reduktionsmittel, beispielsweise Dimethylaminboran oder Natriumborhydrid, zu metallischem Palladium reduziert.

Nach einem weiteren Spülschritt werden die Polymerschichten in einer bevorzugten Verfahrensvariante von den Kunststoffoberflächen wieder entfernt. Hierzu wird eine wäßrige, alkalische Lösung, beispielsweise eine 5 Gewichts-%ige Natronlauge-Lösung bei 50 °C, verwendet.

Nachdem die Substrate erneut gespült worden sind, wird die Nickel- oder Nickel-Legierungsschicht stromlos abgeschieden, vorzugsweise bei einem pH-Wert unter 7. Die Schicht wird ausschließlich auf den freigelegten, aktivierten Kunststoffoberflächen gebildet. Für diese Metallschicht wird vorzugsweise eine Nickel/Phosphor-Legierung eingesetzt. Hierzu wird ein handelsüblicher Nickelelektrolyt verwendet, der ein Hypophosphitsalz als Reduktionsmittel für die Nickelionen enthält.

Alternativ kann auch eine Nickel- oder Nickel/Bor-Schicht abgeschieden werden. Im letzteren Fall wird beispielsweise Dimethylaminboran als Reduktionsmittel verwendet.

Zur Herstellung von elektronischen Zählystemen wird die Nickel-, Nickel/Bor- oder Nickel/Phosphor-Schicht mit einer Dicke von etwa 0,3 µm abgeschieden. In anderen Fällen kann auch eine Nickel/Kobalt/Phosphor- oder Kobalt/Phosphor-Legierungsschicht oder eine Kupferschicht stromlos abgeschieden werden, letztere beispielsweise aus bekannten Bädern, die Formaldehyd, Borane oder Hypophosphite als Reduktionsmittel enthalten, oder eine Palladiumschicht aus bekannten Bädern, die Formaldehyd, Borane oder Ameisensäure als Reduktionsmittel enthalten.

Nachdem die Oberflächen wiederum mit Wasser gespült worden sind, wird eine weitere Metallschicht, beispielsweise aus Kupfer, Nickel, Zinn, Blei, Gold, Silber, Palladium oder deren Legierungen, elektrolytisch abgeschieden. Hierdurch wird die erforderliche Gesamtmetallschichtdicke von 10 bis 50 µm erreicht. Die Abscheidungsbedingungen entsprechen denen, die bei Leiterplatten-Herstellverfahren üblicherweise angewendet werden.

Zur Herstellung von Mitteln zur irreversiblen Informationsspeicherung wird vorzugsweise eine Zinn/Blei- oder Zinn/Zink-Legierungsschicht in einer Dicke von etwa 8 µm auf die erste Metallschicht elektrolytisch aufgebracht. Der Schmelzpunkt dieser Legierungen liegt je nach Zusammensetzung zwischen 196 °C und etwa 350 °C.

Eine Zinn/Blei-Legierung wird üblicherweise aus einem handelsüblichen Bad, enthaltend Tetrafluoroborwasserstoff oder Methansulfonsäure als Leitelektrolyt, abgeschieden. Diese Bäder enthalten neben den Metallsalzen der Legierungsmetalle zusätzlich üblicherweise Glanzbildner und Reduktionsmittel zur Verhinderung der Oxidation der verwendeten Zinn(II)-Salze.

In einer vorteilhaften Verfahrensweise können auch Zinn/Zink-Schichten abgeschieden werden. Geeignete Legierungssysteme enthalten einen Zinkgehalt von 0,5 bis maximal 20 Gewichts-% in der Legierung.

Die Zinn/Zink-Legierungsschicht wird aus einem wäßrigen elektrolytischen Metallisierungsbad abgeschieden, das je eine Zinn- und eine Zinkionenquelle, ferner mindestens einen Komplexbildner und ein Mittel zur Einstellung des pH-Wertes sowie weitere Inhaltsstoffe, wie beispielsweise Kornverfeinerer, Antioxidationsmittel, Glanzbildner, Stabilisatoren, Netzmittel und andere Stoffe enthält.

Das Legierungsbad wird vorzugsweise auf einen pH-Wert unter 7 eingestellt, um gegebenenfalls den auf die Trägermaterialien aufgebrachten Resist beim elektrolytischen Abscheideprozeß nicht zu beschädigen. Zur pH-Wert-Einstellung werden je nach weiterer Badzusammensetzung Säuren oder Basen verwendet. Als Komplexbildner werden beispielsweise Salze oder Ester der Gluconsäure oder Salze von Phosphonsäuren verwendet. Als Salze von Phosphonsäuren werden vorzugsweise die Salze, beispielsweise Alkalisalze, von 2-Phosphono-1,2,4-butantricarbonsäure eingesetzt. Derartige Bäder sind beispielsweise aus J.W. Price, Tin and Tin-Alloy Plating, Electrochemical Publications Limited, Großbritannien, 1983 bekannt. Grundsätzlich können allerdings auch Bäder mit einem pH-Wert über 7 eingesetzt werden.

Zur elektrolytischen Abscheidung der Metallschicht können Anoden aus einer Legierung eingesetzt werden, die sich beim Elektrolysieren auflösen (lösliche Anoden) und die eine Zusammensetzung aufweisen wie die abgeschiedene Schicht, oder unlösliche Anoden, beispielsweise aus Edelstahl, ferner platinierte Titan-Streckmetall- oder Mischoxid-Elektroden, vor allem mit einer Iridiumoxid-(IrO₂)-Beschichtung. Grundsätzlich können auch lösliche und unlösliche Anoden nebeneinander verwendet werden, beispielsweise um über das Verhältnis der Stromanteile beider Anoden das Verhältnis der Legierungsbestandteile im Abscheidungsbad einzustellen. Gegebenenfalls müssen die Metallionen über die entsprechenden Salze ergänzt werden.

Die Anlage zur stromlosen und elektrolytischen Metallabscheidung wird üblicherweise mit verschiedenen Hilfsaggregaten zusätzlich ausgestattet. Beispielsweise enthalten diese Anlagen Mittel zur Badumwälzung und zur Filtration der Behandlungsflüssigkeit.

Falls die Polymerschicht nicht bereits zuvor von den Kunststoffoberflächen entfernt worden ist, kann diese nun nach Abscheidung der Metallschichten entfernt werden (Strippverfahren). Danach wird der Träger mit einer dekorativen Lackschicht überzogen.

Die Kunststoffsubstrate können in einer herkömmlichen Tauchanlage behandelt werden, indem diese nacheinander in die Behälter mit den entsprechenden Behandlungsflüssigkeiten eingetaucht werden. Eine andere bevorzugte Verfahrensweise besteht darin, die Substrate in horizontaler oder vertikaler Ausrichtung in horizontaler Transportrichtung durch eine hierfür geeignete Anlage zu bewegen und mittels geeigneter Vorrichtungen zum In-Kontakt-Bringen der Behandlungsflüssigkeiten in dieser Anlage, beispielsweise mittels Schwalldüsen, zu behandeln.

Nachfolgend werden Ausführungsbeispiele zur näheren Erläuterung der Erfindung angegeben.

Nach den Beispielen werden zur Herstellung von elektronischen Zählsystemen Schaltungsmuster auf den Trägermaterialien entsprechend der schematischen Darstellung der Figur 1 hergestellt. In dieser Figur stellen die dunklen Bereiche die metallischen Schichten und die hellen Bereiche die nicht mit Metall beschichtete Trägeroberfläche dar. Mit der Bezugsziffer 1 ist ein ringförmiges Feld bezeichnet, in dem mittels einer über dem Feld angeordneten Spule ein ringförmiger Strom induziert werden kann. Mit der Bezugsziffer 2 wird ein schmaler Steg bezeichnet, der durch Induktion eines verstärkten Stromes durchgeschmolzen werden kann, so daß der Ring unterbrochen wird. Durch diese Unterbrechung wird in der Schaltung irreversibel eine Dateneinheit gespeichert: Beim erneuten Auslesen mittels der über den Feldern angeordneten Spulen wird in dem nun unterbrochenen Ring kein Strom mehr induziert.

### Beispiel 1:

Für die Zubereitung eines Kilogramms photoempfindlichen Beschichtungsmaterials wurden zunächst ca. 850 mL Wasser mit 5 mL Ammoniak (25 Gewichts-% in Wasser) versetzt und anschließend 100 g Casein (nach Hamarsten; Lieferant beispielsweise Firma Merck AG, Darmstadt, DE) eingerührt. Die entstandene milchige Aufschlämmung wurde unter Erwärmung auf 30°C und ständigem Rühren vollständig gelöst und danach 25 g Ammoniumdichromat unter fortgesetztem Rühren hinzugefügt. Diese an sich bereits gebrauchsfähige Lösung wurde vor dem Beschichtungsauftrag mindestens zwei Stunden in einem UV-undurchlässigen Gefäß zur Ausreifung stehengelassen.

Zwei 40 cm x 60 cm große ABS Folien wurden Rücken an Rücken in einer Weise derart verschweißt, daß lediglich deren Kanten miteinander verschmolzen wurden. Der entstandene Sandwichverbund wurde dann durch Eintauchen in die photoempfindliche Zubereitung vollflächig mit einer geschlossenen Schicht überzogen und im Anschluß daran bei 80°C während 5 Minuten im Trockenofen getrocknet.

Nach erfolgter Abkühlung auf Raumtemperatur wurde durch eine geeignete, das Schaltbild positiv wiedergebende Photomaske mit einer üblichen UV-Lichtquelle belichtet. Anschließend wurde die Potoresistschicht in zwei Stufen in warmem Wasser der Temperaturen 30°C bzw. 50°C entwickelt.

Danach wurden die Muster in einer Beizaktivierungslösung in den nicht von Resist belegten Bereichen des Schaltungsmusters bei einer Temperatur von 60°C während einer Behandlungszeit von 5 Minuten aufgerauht und gleichzeitig durch Palladiumionen belegt. Die Beizaktivierungslösung bestand aus 360 g/L Chromtrioxid und 360 g/L konzentrierter Schwefelsäure sowie 50 bis 100 g/L Palladium, bezogen auf Palladiumchlorid (PdCl₂).

In Anschluß daran wurden die Kunststoffsandwiches gespült und in eine schwefelsaure, 10 g/L Eisen(II)-sulfat enthaltende wäßrige Lösung eingetaucht, um anhaftende Chrom(VI)-ionenreste zu entfernen bzw. zu reduzieren.

Nach einem Spülschritt in Wasser wurden die Sandwiches in einer Reduktionslösung, die 1 g/L Dimethylaminoboran in Borsäure enthaltender Lösung enthielt, etwa 3 Minuten lang behandelt.

Hierbei bildeten sich auf den ABS-Oberflächen metallische, katalytisch wirkende Palladiumcluster aus.

Danach wurde die photoempfindliche Schicht in einer 5 Gewichts-%igen wäßrigen Kalilauge-Lösung bei einer Temperatur von 50 bis 60°C von den ABS-Oberflächen entfernt.

Nach einem Spülschritt wurden die Metallschichten aufgebaut. Hierzu wurden die gespülten ABS-Sandwiches in einem stromlos arbeitenden Vernickelungsbad mit Natriumhypophosphit als Reduktionsmittel beschichtet. Es wurde das Vernickelungsbad Noviganth TC (Firma Atotech Deutschland GmbH, Berlin, DE), eingestellt auf einen pH-Wert von 6,5 bis 6,9, verwendet. Die Nickel/Phosphor-Schicht wurde bei einer Arbeitstemperatur von 45 bis 50°C abgeschieden. Um eine etwa 0,2 bis 0,3 µm dicke Schicht abscheiden zu können, wurden die Substrate 6 bis 7 Minuten lang in dem Bad belassen.

Nach einem weiteren Spülschritt mit Wasser wurde anschließend innerhalb von 10 Minuten eine Schicht einer Zinn-Blei-Legierung bei einer kathodischen Stromdichte von 2 A/dm² aus einem Methansulfonsäure enthaltenden Zinn/Blei-Elektrolyten Sulfolyt TC (Firma Atotech Deutschland GmbH, Berlin, DE) elektrolytisch abgeschieden. Die abgeschiedene Schichtdicke betrug ca. 9 µm.

### Beispiel 2:

Der Verfahrensablauf von Beispiel 1 wurde wie folgt abgewandelt:

Die Sandwiches wurden zunächst in identischer Weise wie in Beispiel 1 mit der photoempfindlichen Schicht versehen, mit dem Schaltungsmuster belichtet und anschließend entwickelt. Danach wurde das ABS-Grundmaterial in den nicht mit Resist belegten Bereichen des Schaltungsmusters durch Eintauchen der Sandwiches in eine auf 60°C erwärmte Chrom/Schwefelsäurebeize, bestehend aus 360 g/L Chromtrioxid und 360 g/L konzentrierte Schwefelsäure, während einer Behandlungszeit von 5 Minuten aufgerauht.

Im Anschluß daran wurden die Kunststoffsandwiches gespült und in eine schwefelsaure, 10 g/L Eisen(II)-sulfat enthaltende wäßrige Lösung eingetaucht, um anhaftende Chrom(VI)-ionen zu entfernen bzw. zu reduzieren.

Nach einem weiteren Spülschritt wurden die Sandwiches in einer Vortauchlösung, die 10 mL/L konzentrierte Schwefelsäure enthielt, 3,5 Minuten lang behandelt und unmittelbar danach ohne weiteren Spülschritt in die Aktivatorlösung Neoganth TC (Firma Atotech Deutschland GmbH, Berlin, DE) eingetaucht. Diese Lösung enthielt einen Komplex aus Palladiumsulfat und 2-Aminopyridin, wobei die Konzentration, berechnet als Pd²⁺, 200 mg/L und der pH-Wert 4,6 betrugen.

Im Anschluß daran wurden die Sandwiches wiederum gespült und danach in einer Borsäure enthaltenden Reduktionslösung, die 1 g/L Dimethylaminoboran enthielt, 3,5 Minuten lang behandelt. Hierbei bildeten sich auf den ABS-Oberflächen metallische, katalytisch wirksame Palladiumcluster aus.

Anschließend wurde die photoempfindliche Schicht in einer 5 Gewichts-%igen wäßrigen Kalilauge-Lösung bei einer Temperatur von 50 bis 60°C entschichtet. Nach einem Spülschritt erfolgte der Metallaufbau analog zu Beispiel 1, allerdings mit einer Zinn/Zink-Legierungsschicht.

Nach einer erneuten Spülung der Platten wurden diese in das Zinn/Zink-Bad eingetaucht, dessen Zusammensetzung in der nachfolgenden Tabelle angegeben ist. Als lösliche Anoden wurden Zinn/Zink-Platten verwendet, die eine Zusammensetzung von etwa 67 Gewichts-% Zinn und 37 Gewichts-% Zink enthielten. Das Bad wurde bei Raumtemperatur betrieben. Die Abscheidung wurde solange durchgeführt, bis eine etwa 8 µm dicke Schicht abgeschieden worden war.

**Tabelle**

| Zinn/Zink-Bad | |
|---|---|
| Zinn-(II)-sulfat, berechnet als Zinn ²⁺ | 15 g/L |
| Zinksulfat, berechnet als Zn²⁺ | 8 g/L |
| Natrium-Gluconat | 110 g/L |
| Triethanolamin | 33 mL/L |
| Polyglycol als Kornverfeinerer | 1,0 g/L |
| Brenzcatechin als Antioxidationsmittel | 1,0 g/L |
| pH-Wert | 4 bis 5 |
| Arbeitstemperatur | 20 °C |
| Kathodische Stromdichte | 2 A/dm² |

Es wurde eine Legierungsschicht mit einer Zusammensetzung von 67 Gewichts-% Zinn und 37 Gewichts-% Zink erhalten.

### Beispiel 3:

Es wurde wie in Beispiel 1 verfahren, jedoch mit der Ausnahme, daß die photoempfindliche Schicht nicht entfernt, sondern als Permanentbeschichtung zum Bestandteil des Schaltungsaufbaus verwendet wurde.

### Beispiel 4:

Es wurde wie im Beispiel 2 verfahren. Entsprechend Beispiel 3 wurde die photoempfindliche Schicht als Permanentbeschichtung zum Bestandteil des Schaltungsaufbaus, indem diese nicht mehr von den Kunststoffsandwiches entfernt wurden.

## Patentansprüche

1. Verfahren zum Strukturieren von Oberflächen von Kunststoffsubstraten mit einem metallischen Schaltungsmuster, bei dem
a) die Oberflächen zunächst mit einer photoempfindlichen Schicht überzogen werden,
b) danach die photoempfindliche Schicht mit dem Schaltungsmuster belichtet und anschließend entwickelt wird und
c) danach die Kunststoffsubstrate mit einer sechswertige Chromverbindungen enthaltenden wäßrigen Lösung aufgerauht werden,
dadurch gekennzeichnet, daß als photoempfindliche Schicht eine mittels sechswertiger Chromverbindungen sensibilisierte Schicht aus Polymeren verwendet wird.

2. Verfahren nach Anspruch 1, dadurch gekennzeichnet, daß als Polymere natürliche oder synthetische Proteine oder Kohlenhydrate oder andere synthetische Polymere eingesetzt werden.

3. Verfahren nach einem der vorstehenden Ansprüche, dadurch gekennzeichnet, daß als Polymere Casein, Gelatine, Gummi arabicum, Schellack, Fischleim, Albumin, Stärke, Polyvinylalkohol, Polyvinylpyrrolidon oder Polyvinylbutyral verwendet werden.

4. Verfahren nach einem der vorstehenden Ansprüche, dadurch gekennzeichnet, daß die photoempfindliche Schicht zusätzlich Silber, Kupfer oder Eisen, Verbindungen dieser Elemente oder deren Mischungen enthält.

5. Verfahren nach einem der vorstehenden Ansprüche, dadurch gekennzeichnet, daß die photoempfindliche Schicht durch Siebdruck auf den Kunststoffoberflächen gebildet wird.

6. Verfahren nach einem der vorstehenden Ansprüche, dadurch gekennzeichnet, daß der sechswertige Chromverbindungen enthaltenden wäßrigen Lösung zum Aufrauhen zusätzlich Verbindungen von für eine stromlose Metallabscheidung katalytisch aktiven Metallen zugesetzt werden.

7. Verfahren nach einem der Ansprüche 1 bis 5, dadurch gekennzeichnet, daß die aufgerauhten Kunststoffoberflächen zur nachfolgenden Metallisierung dem folgenden weiteren Verfahrensschritt unterworfen werden:
d) In-Kontakt-Bringen des Kunststoffsubstrats mit einem für die stromlose Metallabscheidung geeigneten katalytisch aktiven Metall.

8. Verfahren nach einem der vorstehenden Ansprüche, dadurch gekennzeichnet, daß Metallschichten auf die mit dem katalytisch aktiven Metall behandelten Kunststoffoberflächen in folgender Weise aufgebracht werden:
e) stromloses Abscheiden eines Metalls auf dem Kunststoffsubstrat,
f) danach elektrolytisches Abscheiden eines Metalls oder einer Metalllegierung auf dem Kunststoffsubstrat.

9. Verfahren nach Anspruch 8, dadurch gekennzeichnet, daß die Polymerschicht vor Verfahrensschritt e) von den Kunststoffoberflächen entfernt wird.

10. Verfahren nach einem der vorstehenden Ansprüche, dadurch gekennzeichnet, daß als für die stromlose Abscheidung von Metallen geeignetes katalytisches Metall ein mittels Zinn-Verbindungen stabilisiertes Palladium-Kolloid verwendet wird.

11. Verfahren nach einem der vorstehenden Ansprüche, dadurch gekennzeichnet, daß zum stromlosen Metallabscheiden eine Lösung zur Abscheidung von Nickel oder dessen Legierungen verwendet wird.

12. Verfahren nach einem der vorstehenden Ansprüchen, dadurch gekennzeichnet, daß zum elektrolytischen Metallabscheiden eine Lösung zur Abscheidung einer Zinn/Zink- oder einer Zinn/Blei-Legierung verwendet wird.

13. Verfahren zur Herstellung von Mitteln zur irreversiblen Informationsspeicherung, bestehend aus einem Kunststoffsubstrat mit oberflächlich aufgebrachten metallischen Strukturen aus elektrisch miteinander verbundenen Feldern, wobei die Felder im wesentlichen aus einem Ring gebildet sind, in dem ein elektrischer Strom induziert werden kann und wobei der Ring an mindestens einer Stelle durch einen so schmalen Steg geschlossen ist, daß der induzierte Strom ausreicht, die den Steg-bildende Metallschicht zu schmelzen und den Steg zu unterbrechen, nach einem der Ansprüche 8 bis 12 mit folgenden weiteren Verfahrensmerkmalen:
- als Kunststoff wird ein Acrylnitril/Butadien/Styrol-Copolymer verwendet;
- die photoempfindliche Schicht wird an den Stellen belichtet, die den zu erzeugenden Metallstrukturen nicht entsprechen;
- die elektrolytisch abgeschiedene Metallschicht besteht aus einer bei Temperaturen unterhalb von 350 °C schmelzenden, Eutektika bildenden Legierungsmetallschicht.

14. Verfahren zur Herstellung elektronischer Zählsysteme, insbesondere von Telefonkarten, nach Anspruch 13.

15. Verfahren zum Strukturieren von Oberflächen von Kunststoffsubstraten mit einem metallischen Schaltungsmuster, gekennzeichnet durch einzelne oder alle neuen Merkmale oder Kombinationen der offenbarten Merkmale.

16. Verfahren zur Herstellung von Mitteln zur irreversiblen Informationsspeicherung, bestehend aus einem Kunststoffsubstrat mit oberflächlich aufgebrachten metallischen Strukturen aus elektrisch miteinander verbundenen Feldern, wobei die Felder im wesentlichen aus einem Ring gebildet sind, in dem ein elektrischer Strom induziert werden kann und wobei der Ring an mindestens einer Stelle durch einen so schmalen Steg geschlossen ist, daß der induzierte Strom ausreicht, die den Steg bildende Metallschicht zu schmelzen und den Steg zu unterbrechen, gekennzeichnet durch einzelne oder alle neuen Merkmale oder Kombinationen der offenbarten Merkmale.
